# DEMANDE DE BREVET EUROPEEN

(11) **EP 1 096 557 A1**
(43) Date de publication de la demande: **02.05.2001**
(21) Numéro de dépôt: 00410127.5
(22) Date de dépôt: 24.10.2000
(51) Int. Cl.: H01L 21/331

(54) **Procédé de définition de deux zones autoalignées à la surface supérieure d'un substrat**

(30) Priorité: 25.10.1999 FR 9913543
(71) Demandeur: STMicroelectronics SA, 94250 Gentilly Cedex (FR)
(72) Inventeur: Gris, Yvon, 38210 Tullins (FR)
(74) Mandataire: de Beaumont, Michel

(57) **Abrégé**

L'invention concerne un procédé de définition sur la surface supérieure d'un substrat (21-22) de deux zones autoalignées (A1, A2), comprend les étapes consistant à déposer une couche de protection (23) ; déposer une couche de recouvrement (24) ; ouvrir l'ensemble des couches de recouvrement et de protection à un emplacement (25) correspondant sensiblement à la frontière désirée des deux zones ; former un espaceur (26, 27) le long du bord de l'ouverture, cet espaceur ayant une partie arrière adossée à ladite frontière et une partie avant opposée ; ouvrir l'ensemble des couches de protection et de recouvrement derrière la partie arrière de l'espaceur ; et éliminer la couche de protection (23) jusqu'à atteindre la partie arrière de l'espaceur ; d'où il résulte que deux zones autoalignées (A1, A2) sont définies de part et d'autre de la longueur de l'espaceur.

## Description

La présente invention concerne un procédé pour définir deux zones autoalignées à la surface supérieure d'un substrat.

La présente invention s'applique plus particulièrement à la fabrication de composants semiconducteurs et notamment de circuits intégrés.

Lors de la fabrication de circuits intégrés, il est d'usage de réaliser de nombreuses étapes de photolithogravure pour définir des zones et des couches successives sur un substrat semiconducteur. Toutefois, il est bien connu que des zones définies par deux étapes de photolithogravure distinctes (deux masques distincts) ne pourront pas être alignées de façon idéale en raison de l'inévitable tolérance d'alignement entre deux masques successifs.

On a donc développé divers procédés d'autoalignement pour obtenir des zones définies sur la surface supérieure d'un substrat et séparées de distances bien précises.

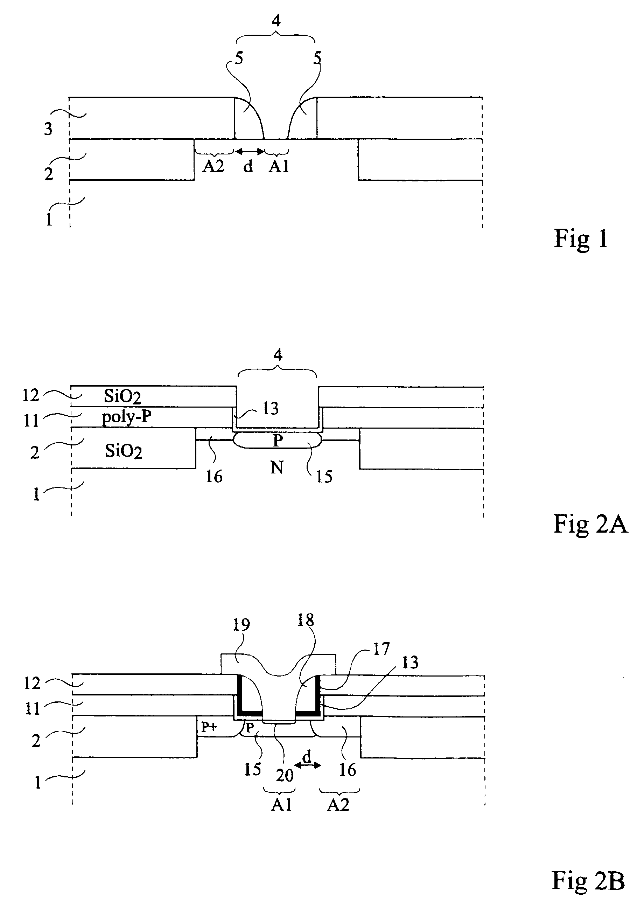

Un exemple général d'une technique d'autoalignement utilisant des espaceurs est illustré en figure 1. Sur un substrat 1, on définit une zone active délimitée par une région d'isolement 2. Dans le cas de substrats semiconducteurs, la région 2 est typiquement une couche d'oxyde épais, par exemple une couche formée par le procédé LOCOS, ou, comme dans l'exemple représenté, un oxyde formé dans une tranchée ménagée dans le substrat. Ensuite, on dépose une couche 3 qui est ouverte dans une région 4 située au-dessus d'une partie de la zone active. Après quoi, on forme de façon classique un espaceur 5 à la frontière de la zone ouverte. On définit ainsi une première zone A1 disposée du côté avant de l'espaceur et une deuxième zone A2 disposée du côté arrière de l'espaceur. La distance entre ces zones ne dépend pas du positionnement successif de deux masques mais uniquement de la longueur de l'espaceur, c'est-à-dire de l'épaisseur de la couche 3 et du mode de formation de l'espaceur. Dans le cas où le substrat 1 est un semiconducteur, la zone A1 subira par exemple une implantation de dopant et la zone A2 sera par exemple modifiée par un dopant contenu sous la partie inférieure de la couche 3 qui sera aussi, ou au lieu de cela, une couche de prise de contact.

Un exemple connu d'application de ce procédé classique à la formation de la région d'émetteur-base d'un transistor NPN est illustré en figures 2A et 2B.

Comme l'illustre la figure 2A, une zone active d'un substrat 1 est délimitée par une tranchée d'oxyde épais 2. Sur cette structure sont successivement formées une couche 11 de silicium polycristallin dopé de type P et une couche 12 d'oxyde de silicium. Une ouverture centrale 4 est gravée. Une étape d'oxydation thermique permet de former une couche d'oxyde mince 13 sur toutes les surfaces exposées de silicium. On procède alors à l'implantation d'un dopant de type P pour former la base intrinsèque 15 du transistor NPN. Pendant le recuit de cette implantation, le dopant de type P contenu dans la couche 11 commence à diffuser dans le substrat pour former une région de base extrinsèque 16.

Aux étapes suivantes, comme l'illustre la figure 2B, on forme un espaceur, par exemple en déposant successivement une couche mince 17 de nitrure de silicium et une couche 18 de silicium polycristallin ou d'oxyde de silicium et en procédant à une gravure anisotrope de la couche 18 puis à une gravure sélective de la couche 17 qui est alors masquée par la couche 18. Enfin, on dépose une couche 19 de silicium polycristallin dopé de type N, qui sert de source pour la formation d'une région peu profonde d'émetteur 20 de type N dans la région de base 15 de type P.

Ainsi, la distance latérale entre l'émetteur 20 et la base extrinsèque 16 est définie par la longueur d de l'espaceur et par les caractéristiques du procédé de fabrication.

Le procédé d'autoalignement décrit ci-dessus donne toute satisfaction mais l'on notera qu'il existe beaucoup de circonstances dans lesquelles il n'est pas applicable. Par exemple, le procédé ne pourra pas être utilisé si le matériau de la couche 3 (du silicium polycristallin 11 dopé de type P dans le cas particulier de la figure 2A) perturbe lors de son dépôt le substrat dans la zone A1. Un problème se pose également si, pendant la gravure de la couche 3, il y a un risque de dégradation des propriétés de la zone A1. Ce dernier problème se pose par exemple si la partie supérieure du substrat est recouverte d'une mince couche active, par exemple du SiGe et que la couche 3 est du silicium polycristallin ; la gravure du silicium polycristallin entraînera un fort risque de surgravure du SiGe.

Ainsi, la présente invention prévoit un nouveau procédé de formation de deux zones autoalignées sur un substrat semiconducteur.

La présente invention prévoit un tel procédé applicable notamment au cas où les zones localisées sont définies sur une couche épitaxiée de silicium-germanium.

Un autre objet de la présente invention est de réaliser une structure de transistor NPN à base en silicium-germanium.

Pour atteindre ces objets, la présente invention prévoit un procédé de définition sur la surface supérieure d'un substrat de deux zones autoalignées, comprenant les étapes suivantes :
déposer une couche de protection ;
déposer une couche de recouvrement ;
ouvrir l'ensemble des couches de recouvrement et de protection à un emplacement correspondant sensiblement à la frontière désirée des deux zones ;
former un espaceur le long du bord de l'ouverture, cet espaceur ayant une partie arrière adossée à ladite frontière et une partie avant opposée ;
ouvrir l'ensemble des couches de protection et de recouvrement derrière la partie arrière de l'espaceur ; et
éliminer la couche de protection jusqu'à atteindre la partie arrière de l'espaceur ;
d'où il résulte que deux zones autoalignées sont définies de part et d'autre de la longueur de l'espaceur.

Selon un mode de réalisation de la présente invention, le procédé comprend l'étape consistant à insérer un matériau dans l'interstice compris entre le substrat et la couche de recouvrement.

Selon un mode de réalisation de la présente invention, ledit matériau est propre à réaliser une diffusion dans le substrat sous la partie restante de la couche de recouvrement.

Selon un mode de réalisation de la présente invention, le substrat est un substrat semiconducteur d'un premier type de conductivité revêtu d'une couche du type de conductivité opposé à faible niveau de dopage, la couche de protection est en oxyde de silicium, et la couche de recouvrement est formée de la superposition d'une couche de silicium polycristallin dopée du deuxième type de conductivité et d'une couche de nitrure de silicium.

Selon un mode de réalisation de la présente invention, après l'étape d'élimination de la couche de protection, il est prévu de déposer uniformément une couche conductrice par exemple une couche de silicium polycristallin par dépôt chimique en phase vapeur.

Selon un mode de réalisation de la présente invention, la couche du type de conductivité opposé à faible niveau de dopage est une couche épitaxiale de silicium-germanium.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 précédemment décrite illustre une structure classique d'espaceur ;
les figures 2A et 2B précédemment décrites, illustrent des étapes de formation de la région d'émetteur-base d'un transistor NPN selon un procédé classique ;
les figures 3A à 3D sont des vues en coupe illustrant des étapes de définition de deux zones autoalignées selon la présente invention ;
les figures 4A à 4D représentent des étapes successives d'un exemple d'application du procédé selon l'invention ; et
les figures 5A et 5B représentent des étapes successives d'un autre exemple d'application de l'invention.

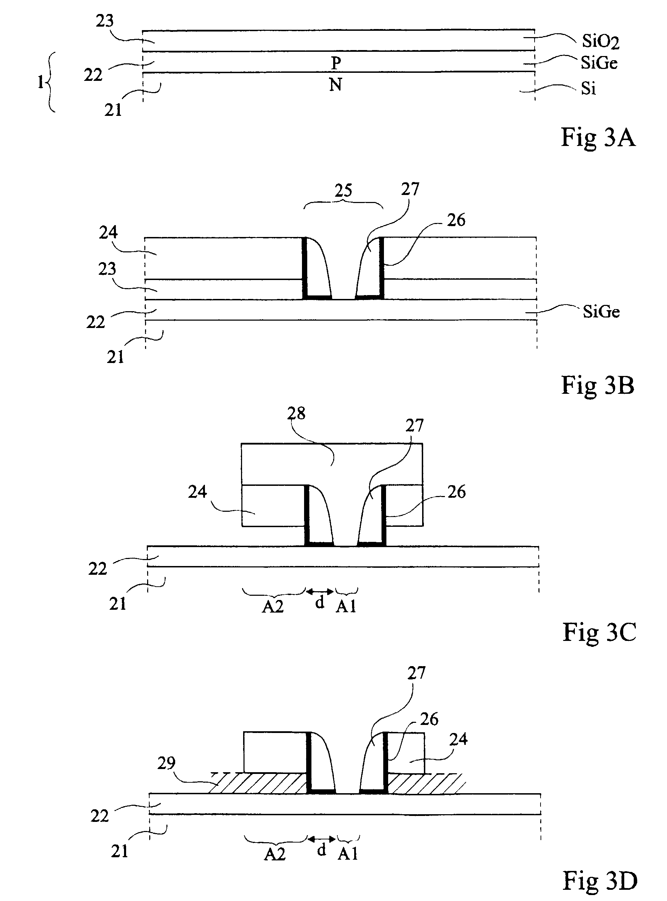

Les figures 3A à 3D sont des vues en coupe schématiques illustrant de façon générale des étapes essentielles d'un procédé selon la présente invention.

On considère à titre d'exemple un substrat 1, constitué d'une tranche de silicium monocristallin de type N 21 sur laquelle est formée une couche épitaxiée de silicium-germanium de type P 22. Bien que cet exemple particulier soit considéré ici, la présente invention vise tout type de substrat. On notera en effet que les étapes illustrées en figures 3A à 3D ne dépendent pas de la nature du substrat. Toutefois, de façon générale, on considérera le cas où le substrat risquerait d'être dégradé par le dépôt ou la gravure d'une première couche active déposée sur celui-ci, telle une couche de silicium polycristallin fortement dopée.

Ainsi, selon la présente invention, comme le représente la figure 3A, on prévoit dans une première étape de former sur le substrat une couche de protection 23 dont le dépôt sur la face supérieure du substrat 1 peut être réalisé dans des conditions propres à ne pas dégrader ce substrat en volume ou en surface. La couche de protection 23 sera par exemple une couche de SiO₂ déposée par voie chimique en phase vapeur. Comme on le verra ci-après, cette couche est une couche sacrificielle qui sera éliminée dans les étapes ultérieures du procédé et l'on pourra choisir une couche en tout matériau protégeant le substrat et pouvant être gravé sélectivement de façon isotrope par rapport au substrat et par rapport à des matériaux déposés ultérieurement, comme cela ressortira de la description ci-après.

Comme le représente la figure 3B, la couche 23 est revêtue d'une couche de recouvrement 24. Une ouverture 25 est formée dans l'ensemble des couches de recouvrement et de protection 24 et 23 et, à la frontière de l'ouverture, est formée un espaceur, constitué par exemple d'une couche de nitrure de silicium 26 et d'une couche d'oxyde de silicium 27. Tout autre type d'espaceur pourrait être utilisé.

A l'étape illustrée en figure 3C, la structure a été recouverte d'une couche de résine 28 débordant par rapport à l'ouverture 25. La couche 24 est gravée de façon anisotrope, pour obtenir des flancs sensiblement verticaux puis la couche 23 est éliminée par gravure isotrope. Cette gravure isotrope est prolongée suffisamment longtemps pour que la couche 23 soit complètement éliminée même dans ses portions enserrées entre la couche 24 et le substrat.

Comme le représente la figure 3D, et comme cela sera décrit ci-après dans le cadre d'exemples particuliers, on pourra ensuite déposer sous la couche 24, au-dessus de la couche 22, un matériau 29 susceptible d'interagir avec la région sous-jacente pour former un contact et/ou une source de dopant. On obtient ainsi comme dans le cas de la figure 1, une première zone A1 correspondant à l'ouverture à l'intérieur de l'espaceur et une deuxième zone active A2 située sous la couche 29.

La distance d entre les zones A1 et A2 est parfaitement définie par la longueur de l'espaceur, indépendamment du fait que le masque ayant servi à délimiter la région de résine 28 est centré ou non par rapport à l'ouverture 25. C'est pour bien illustrer cette caractéristique de l'invention que le masque correspondant à la couche 28 a été représenté comme décentré en figures 3C et 3D et on voit que cela n'a pas d'influence sur le résultat obtenu.

Un avantage de la présente invention est que la zone A1 correspondant à l'ouverture 25 est protégée de toute interaction avec le matériau 29.

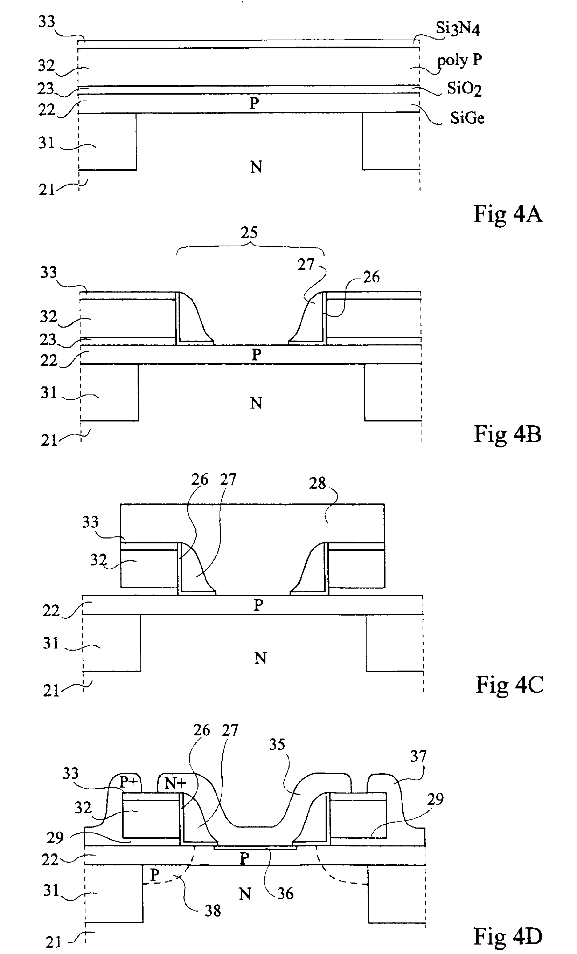

Une application particulière de la présente invention à la réalisation d'une structure autoalignée de transistor à base en silicium-germanium est illustrée en relation avec les figures 4A à 4D. Dans ces figures, seule la structure émetteur-base est représentée, et notamment les couches enterrées et la zone de contact de collecteur ne sont pas représentées.

Comme le représente la figure 4A, la structure est formée à partir d'une tranche de silicium monocristallin 21 de type N sur laquelle a été formée par épitaxie une couche de silicium-germanium 22 de type P destinée à constituer la base d'un transistor bipolaire. Une zone active est définie par une tranchée 31 remplie d'un isolant, par exemple de l'oxyde de silicium. Ainsi, de façon classique, la couche de silicium-germanium déposée par épitaxie au-dessus de la structure sera monocristalline au-dessus de la zone active définie dans la région 21 et polycristalline au-dessus de l'oxyde de silicium 31. La couche 22 de SiGe aura par exemple une épaisseur de 60 nm et un niveau de dopage compris entre 10¹⁸ et 10¹⁹ atomes/cm³.

La couche de protection 23 déposée sur la couche 22 est par exemple une couche d'oxyde de silicium d'une épaisseur de 30 nm. La couche de recouvrement 24 est par exemple constituée d'une couche 32 de silicium polycristallin dopée de type P d'une épaisseur de 100 nm et d'une couche 33 de nitrure de silicium d'une épaisseur de 30 nm. La couche 32 de silicium polycristallin est très fortement dopée, par exemple entre 10²⁰ et 10²¹ atomes/cm³.

Ensuite, comme le représente la figure 4B, on forme une ouverture 25 dans l'ensemble des couches 33, 32 et 23, de façon sensiblement centrale par rapport à la zone active. Un espaceur est formé du côté interne de cette ouverture, et comprend par exemple une couche 26 de nitrure de silicium revêtue d'une couche 27 d'oxyde de silicium.

Comme le représente la figure 4C, on dépose ensuite une couche de résine photosensible 28 qui recouvre l'ouverture 25 et en déborde latéralement du côté arrière de l'espaceur 26-27. On procède ensuite à une gravure anisotrope des couches 33 et 32 puis à une gravure isotrope de la couche de protection sacrificielle 23 pour éliminer complètement cette couche sous la couche 32.

A partir de la structure de la figure 4C qui est caractéristique de la présente invention, on peut réaliser un transistor NPN tel que représenté dans la figure 4D en déposant de façon conforme, par voie chimique en phase vapeur, une couche de silicium polycristallin non dopé qui remplit complètement l'intervalle entre les couches 22 et 32 et est désignée à cet emplacement par la référence 29. Cette couche est gravée au-dessus de la portion restante de la couche 33 pour délimiter une première portion de silicium polycristallin centrale 35 qui correspondra à une couche de contact d'émetteur et qui sera dopée de type N⁺ de façon à former par diffusion une zone d'émetteur peu profonde 36, et une deuxième portion de couche de silicium polycristallin 37 qui sera dopée de type P⁺. Lors des recuits, le dopant de type P (par exemple du bore) contenu dans la couche de silicium polycristallin 32 diffuse à travers le silicium polycristallin interstitiel 29 dans le substrat 21 pour servir de zone de contact de base et former une région diffusée de base extrinsèque 38. Cette région 38 masque les éventuels défauts cristallins générés dans la zone voisine du raccordement entre le substrat 21 et l'oxyde 31. Grâce à l'invention, la distance latérale entre l'émetteur 36 et la base extrinsèque 38 est définie de façon autoalignée sans qu'il soit nécessaire d'avoir recours à des alignements de masques successifs.

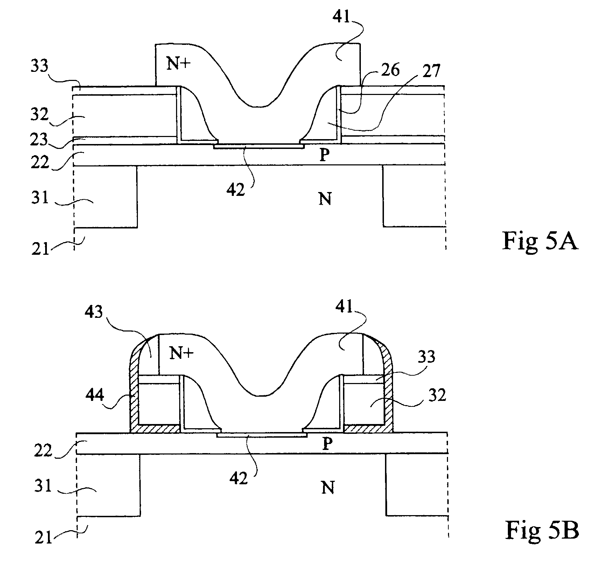

Les figures 5A et 5B illustrent une variante du procédé décrit en relation avec les figures 4A à 4D.

Après l'étape décrite précédemment en relation avec la figure 4B, on procède au dépôt d'une couche de silicium polycristallin 41 qui est fortement dopée de type N de façon à constituer une zone de reprise de contact d'émetteur à partir de laquelle sera diffusée une région très peu profonde d'émetteur 42. La couche 41 est gravée latéralement et l'on procède à la formation d'espaceurs latéraux 43, par exemple en oxyde de silicium.

En se servant du masque défini par l'espaceur 43, on procède ensuite à la gravure des couches 33, 32, et 23 et la couche 23 est complètement éliminée sous la couche 32. Après cela, on procède au dépôt conforme par voie chimique en phase vapeur d'une couche de silicium polycristallin 44, par exemple dopée in-situ entre 10²⁰ et 10²¹ atomes/cm³, et l'on procède à une gravure anisotrope de sorte qu'il demeure simplement la partie de la couche 44 située sous la région 32 et le long des bords latéraux de la fenêtre extérieure, comme cela est représenté.

Après les étapes ci-dessus dont le résultat est représenté en figure 5B, on pourra procéder à une siliciuration des surfaces apparentes de silicium.

Par ce procédé, on obtient :
- un autoalignement entre la base extrinsèque et l'émetteur,
- un autoalignement du siliciure,
- un procédé n'utilisant pas de recuit importants.

De nombreuses autres variantes de la présente invention apparaîtront à l'homme de l'art. Par exemple, lors de l'étape de la figure 5B, au lieu de déposer une couche de silicium polycristallin, on pourra procéder au dépôt conforme d'une couche de tungstène, de préférence précédé du dépôt d'une couche d'accrochage en TiN, ces dépôts étant réalisés de façon conforme, par exemple par voie chimique en phase vapeur. Après une étape de siliciuration, on procède à une gravure du tungstène n'ayant pas réagi avec le silicium. Dans ce dernier cas, la couche 32 n'est plus nécessairement une couche de silicium polycristallin, car elle n'a plus de fonction de source de dopant.

Bien entendu, la présente invention est susceptible de nombreuses variantes et modifications qui apparaîtront à l'homme de l'art, les aspects essentiels de l'invention étant définis par les revendications ci-après.

## Revendications

1. Procédé de définition sur la surface supérieure d'un substrat de deux zones auto-alignées (A1, A2), caractérisé en ce qu'il comprend les étapes suivantes :
déposer une couche de protection (23) ;
déposer une couche de recouvrement (24) ;
ouvrir l'ensemble des couches de recouvrement et de protection à un emplacement (25) correspondant sensiblement à la frontière désirée des deux zones ;
former un espaceur (26, 27) le long du bord de l'ouverture, cet espaceur ayant une partie arrière adossée à ladite frontière et une partie avant opposée ;
ouvrir l'ensemble des couches de protection et de recouvrement derrière la partie arrière de l'espaceur ;
éliminer la couche de protection (23) jusqu'à atteindre la partie arrière de l'espaceur ; et
insérer un matériau (29) dans l'interstice compris entre le substrat (1) et la couche de recouvrement (24).

2. Procédé selon la revendication 1, caractérisé en ce que la couche supérieure (22) du substrat (1) est une couche épitaxiale de silicium-germanium.

3. Procédé selon la revendication 1, caractérisé en ce que ledit matériau (29) est propre à réaliser une diffusion dans le substrat sous la partie restante de la couche de recouvrement.

4. Procédé selon l'une quelconque des revendications 1 à 3, caractérisé en ce que la couche de protection (23) est en oxyde de silicium, et en ce que la couche de recouvrement est formée de la superposition d'une couche de silicium polycristallin (32) dopée du deuxième type de conductivité et d'une couche de nitrure de silicium (33).

5. Procédé selon la revendication 1 ou 2, caractérisé en ce que, après l'étape d'élimination de la couche de protection, il comprend l'étape consistant à déposer uniformément une couche conductrice par dépôt chimique en phase vapeur.

6. Procédé selon la revendication 4, caractérisé en ce que, après l'étape d'élimination de la couche de protection, il comprend l'étape consistant à déposer uniformément une couche de silicium polycristallin par dépôt chimique en phase vapeur.
